# EUROPÄISCHE PATENTSCHRIFT

(11) **EP 1 202 582 B1**
(45) Veröffentlichungstag und Bekanntmachung des Hinweises auf die Patenterteilung: **14.03.2007**
(21) Anmeldenummer: 01124635.2
(22) Anmeldetag: 16.10.2001
(51) Int. Cl.: H04Q 1/10, H05K 5/03, H05K 7/18

(54) **Gehäuse für Telekommunikationsanlagen**
Housing for telecommunication exchanges
Boîtier pour centraux de télécommunications

(30) Priorität: 26.10.2000 DE 20018740 U
(43) Veröffentlichungstag der Anmeldung: 02.05.2002
(73) Patentinhaber: DeTeWe Systems GmbH, 10997 Berlin (DE)
(72) Erfinder: Klingbeil, Manfred, 12359 Berlin (DE); Krämer, Katharina, 12047 Berlin (DE); Krispin, Harro, 13503 Berlin (DE); Pütz, Peter, 12103 Berlin (DE); Schulz, Jürgen, 12107 Berlin (DE)
(74) Vertreter: Fischer, Uwe

(56) Entgegenhaltungen:
- EP-A- 0 658 076
- DE-A- 3 015 585
- DE-A- 3 642 342
- DE-U- 9 203 115

## Beschreibung

Die Erfindung betrifft ein Gehäuse für Telekommunikationsanlagen gemäß dem Oberbegriff des Anspruchs 1.

Die europäische Patentanmeldung EP 0 658 076 A1 beschreibt ein solches Gehäuse für Telekommunikationsanlagen gemäß dem Oberbegriff des Anspruchs 1. Durch einen modularen Aufbau ist das Gehäuse durch äußerlich gleiche Module zu leistungsfähigeren, größeren Anlagen erweiterbar. Das einzelne Modul ist zur Wandmontage vorgesehen und besteht aus einer Bodenwanne mit Baugruppenträger und einer Abdeckung mit Lüftungsschlitzen.

Aus der DE 92 03 115 U1 ist ein Gehäuse für eine Telekommunikationsanlage, insbesondere für eine Ferneprechnebenstellenanlage, bekannt, das ein Unter- oder Bodenteil zur Aufnahme von elektronischen Bauteilen und Anschlußklemmen sowie eine gegen unbefugtes Öffnen gesicherte Abdeckhaube aufweist. Die Abdeckhaube des Gehäuses ist im mittleren Bereich leicht eingezogen und besitzt dort ein Leuchtenfeld mit Anzeigeleuchten für das Vorhandensein der Versorgungsspannung, den Belegtzustand der Leitungen und dergleichen.

Die obere Stirnwand der einstückig aus Kunststoff gespritzten Abdeckhaube weist Belüftungsschlitze auf, die zusammen mit Öffnungen im Bereich der unteren Stirnwand eine Wärmeabfuhr ermöglichen. An einer Längsseite weist die Abdeckhaube Rastorgane auf, die mit komplementären Rastorganen des Unterteils zusammenwirken und die Abdeckhaube im aufgesetzten Zustand an der einen Längsseite verriegeln, während das Unterteil an der gegenüberliegenden Längsseite einen federnden, in Richtung zur Innenwand der zugeordneten Abdeckhauben-Seitenwand weisenden Sperrhaken besitzt, der nach dem Aufdrücken der Haube in eine innere Ausnehmung der Seitenwand eindringt und die Haube verriegelt. Zum Öffnen des Gehäuses ist im Unterteil des Gehäuses eine Öffnung vorgesehen, durch die ein Werkzeug einführbar ist und mit dem der Sperrhaken aus der Ausnehmung gehebelt werden kann, so daß die Abdeckhaube freigegeben wird.

Derartige Gehäuse für Telekommunikationsanlagen weisen üblicherweise eine vorgegebene Baugröße auf, die der Anzahl aufzunehmender elektrischer bzw. elektronischer Baugruppen wie Stromversorgungseinrichtung, Leiterplatten sowie Anschlußklemmen angepaßt ist. Die aus Kunststoff bestehende und mittels Spritzgußtechnik hergestellte Abdeckhaube ist beim Einwirken äußerer Kräfte leicht zerstörbar oder weist eine solche Dicke oder zusätzliche Verstärkungselemente auf, daß das Volumen des Gehäuses deutlich größer wird als für die Aufnahme der elektrischen und elekronischen Baugruppen erforderlich ist. Dadurch sind auch der Größe derartiger Gehäuse für Telekommunikationsanlagen Grenzen gesetzt.

Für unterschiedlich große Telekommunikationsanlagen werden daher voneinander verschiedene Gehäuseformen entwickelt, die der jeweiligen Anzahl aufzunehmender elektrischer und elektronischer Baugruppen angepaßt ist. Die verschiedenen Gehäuseformen und -größen erfordern einen entsprechend aufwendigen Herstellungsprozeß sowie eine aufwendige Lagerhaltung zur Bereitstellung der unterschiedlichen Produktformen und -größen. Dabei bleibt gleichwohl das Problem der leichten Zerstörbarkeit insbesondere der Abdeckhauben der Gehäuse für Telekommunikationsanlagen bzw. bei entsprechenden Dicken der Kunststoff-Abdeckhauben die geringe Raumausnutzung ungelöst.

Ein weiteres Problem besteht darin, daß zur Sicherung der Gehäuse für Telekommunikationsanlagen gegen unbeabsichtigtes oder unbefugtes Öffnen Verriegelungseinrichtungen wie bei der DE 92 03 115 U1 vorgesehen sind, die mit Spezialwerkzeugen oder nur umständlich für den befugten Zugang zu entriegeln sind. Auch dabei besteht die Gefahr der Zerstörung der Kunststoff-Abdeckhaube bzw. der Verriegelungsteile, so daß entsprechender Ersatz erforderlich wird.

Der vorliegenden Erfindung liegt daher die Aufgabenstellung zugrunde, ein Gehäuse für Telekommunikationsanlagen zu schaffen, das stabil und mit einem ansprechenden Design ausgebildet ist, das allen Sicherheitsanforderungen einschließlich einer Sicherung gegen unbeabsichtigtes und/oder unbefugtes Öffnen genügt, das zur Aufnahme elektrischer und elektronischer Baugruppen eine optimale Baugröße aufweist und das bei gleicher Bauform in unterschiedlichen Größen bei geringen Herstellungs- und Lagerhaltungskosten herstellbar ist.

Diese Aufgabe wird erfindungsgemäß durch die Merkmale des Anspruchs 1 gelöst.

Die erfindungsgemäße Lösung ermöglicht es, ein Gehäuse für Telekommunikationsanlagen in unterschiedlichen Baugrößen bei gleicher Bauform bereitzustellen, das höchsten Stabilitätsanforderungen genügt und gleichwohl ein ansprechendes Design ermöglicht und aufgrund seines modularen Aufbaus bzw. seiner modularen Erweiterbarkeit mit geringen Herstellungs- und Lagerkosten verbunden ist. Durch die Kombination von Stahlblechteilen und Kunststoff gewährleistet das erfindungsgemäße Gehäuse nicht nur ein Höchstmaß an Stabilität, sondern auch an Sicherheit, da dem Gehäuse durch die Verbindung von Stahlblechteilen mit Kunststoff-Formteilen allein bereits eine höhere Stabilität verliehen wird, die durch die Formgebung bzw. Profilierung der Kunststoffteile noch zusätzlich erhöht wird.

Insbesondere die Verbindung der aneinanderreihbaren Kunststoff-Formteile an ihren Innenflächen mit den Außenflächen des Mantelblechs schafft nach einem weiteren Merkmal der Erfindung eine optimale Stabilität und darüber hinaus eine leichte Herstellbarkeit, da das Mantelblech die entsprechende Montageplattform bildet.

Die modulare Ausgestaltung des erfindungsgemäßen Gehäuses kann in mannigfaltiger Weise realisiert werden. So können die aneinanderreihbaren Kunststoff-Formteile identisch ausgebildet werden und die Breite des Mantelblechs im wesentlichen ein ganzzahliges Vielfaches der Breite der aneinanderreihbaren Kunststoff-Formteile sein.

Alternativ können die aneinanderreihbaren Kunststoff-Formteile dieselbe Länge aber unterschiedliche Breiten aufweisen, wobei die Breite des Mantelblechs im wesentlichen der Summe der Breite aller aneinanderreihbaren Kunststoff-Formteile ist.

Schließlich kann die Breite der Kunststoff-Formteile jeweils ein ganzzahliges Vielfaches der Breite eines Grundelements der Kunststoff-Formteile betragen.

Die Kombination von Kunststoff-Formteilen und einem Mantelblech zur Herstellung unterschiedlich großer Abdeckhauben ermöglicht es weiterhin, dem jeweiligen Bauteil Funktionen zuzuweisen, die durch dessen Werkstoffeigenschaften für das betreffende Bauteil besonders geeignet und damit leicht herstellbar sind. So weisen nach einem weiteren Merkmal der erfindungsgemäßen Lösung die aneinanderreihbaren Kunststoff-Formteile ein beispielsweise durch Kunststoff-Spritzguß leicht herstellbares Lüftungsgitter auf, das unterhalb des Lüftungsgitters befindliche Öffnungen im gestanzten Mantelblech abdeckt.

Zur Verbindung der Kunststoff-Formteile mit dem Mantelblech sind die aneinanderreihbaren Kunststoff-Formteile mit federnden Haken am Mantelblech zur Montagehilfe und Ausrichtung der aneinanderreihbaren Kunststoff-Formteile festlegbar. Weiterhin weisen die aneinanderreihbaren Kunststoff-Formteile durch Befestigungslaschen im Mantelblech steckbare, im wesentlichen senkrecht von der Innenfläche der aneinanderreihbaren Kunststoff-Formtteile abstehende Befestigungsstifte auf, auf die Federmuttern aufsteckbar sind und damit die Kunststoff-Formteile mit dem Mantelblech verbinden.

Durch diese Form der Verbindung wird gleichzeitig das Mantelblech der Formgebung der Kunststoff-Formteile angepaßt, indem das Mantelblech durch das Aufstecken der Federmuttern und Arretieren der Federmuttern in einer vorgegebenen Stellung in die entsprechende Form hineingezogen wird.

Nach einem weiteren Merkmal der Erfindung weisen die aneinanderreihbaren Kunststoff-Formteile an ihren einander zugewandten Seitenkanten sich überdeckende Flächenbereiche auf, so daß eine nahtlose Aneinanderreihung der Kunststoff-Formteile möglich ist und ein geschlossenes, gefälliges Design und ein gegen das Eindringen von Fremdteilchen sicherer Abschluß des Gehäuses geschaffen wird.

Ebenfalls einer geschlossenen äußeren Bauform und einem gefälligen Design dient das weitere Merkmal der Erfindung, wonach die ebenfalls als Kunststoff-Formteile ausgebildeten Seitenteile der Abdeckhaube einen die Seitenkante des Mantelblechs sowie die jeweils äußeren aneinanderreihbaren Kunststoff-Formteile teilweise und die Seitenteile des Gehäusebodens abdeckenden, hochgezogenen Rand aufweisen und über zueinander ausgerichtete Formschlußelemente mit dem Mantelblech verbunden sind.

Zur Sicherung der Abdeckhaube und damit des Telekommunikationsanlagengehäuses gegen unbeabsichtigtes und/oder unbefugtes Öffnen ist nach einem weiteren Merkmal der erfindungsgemäßen Lösung ein in die Fläche der Seitenteile eingelassener Schieber vorgesehen, der zur Verbindung mit dem Gehäuseboden eine Formschlußöffnung des Gehäusebodens hintergreift.

Da die Seitenteile unabhängig von der Baugröße des Gehäuses und damit der Anzahl aneinandergereihter Kunststoff-Formteile die Verbindung mit dem Gehäuseboden herstellen, ist eine Verriegelung des Gehäuses im Bereich der Seitenteile optimal und durch die Auswahl eines in die Seitenteile eingelassenen Schiebers sowohl unter gestalterischen Gesichtspunkten als auch im Hinblick auf Sicherheitsanforderungen optimal.

Als weitere Sicherheitsmaßnahme gegen ein unbefugtes oder unbeabsichtigtes Öffnen des Gehäuses kann der Schieber mit einem die Verstellung des Schiebers blockierenden Element versehen bzw. das die Verstellung des Schiebers blockierende Element im Verstellweg des Schiebers angeordnet werden.

Zur Ausrichtung der Abdeckhaube auf den Gehäuseboden greift nach einem weiteren Merkmal der Erfindung im montierten Zustand der Abdeckhaube eine von der Innenfläche der Seitenteile abstehende Zentrierkontur in einen Zentrierschlitz des Gehäusebodens ein.

Durch die Kombination von Kunststoff-Formteilen mit einem aus Stahlblech hergestellten Mantelblech kann das Mantelblech wahlweise aus gewalztem oder gerolltem Stahlblech oder aus einem Strangpreßprofil bestehen.

Anhand eines in der Zeichnung dargestellten.Ausführungsbeispieles soll der der Erfindung zugrunde liegende Gedanke näher erläutert werden. Es zeigen:
- Figuren 1a und 1b -: perspektivische Darstellungen zweier unterschiedlich großer, modular aufgebauter Gehäuse für Telekommunikationsanlagen;
- Figur 2 -: eine Frontansicht der Abdeckhaube des Gehäuses gemäß Figur 1a;
- Figur 3 -: einen Schnitt durch die Abdeckhaube entlang der Linien A-A gemäß Figur 2;
- Figur 4 -: eine Draufsicht auf ein Seitenteil der Abdeckhaube gemäß Figur 2;
- Figur 5 -: eine Draufsicht auf das Bodenblech des Gehäusebodens mit Steckeraufnahmen und Aufnahmen für elektrische und elektronische Bauteile;
- Figur 6 -: eine Ansicht eines Seitenteils des Gehäusebodens;
- Figur 7 -: eine Draufsicht auf ein Mantelblech der Abdeckhaube gemäß der Figuren 2 und 3;
- Figur 8 -: eine Seitenansicht des Mantelblechs gemäß Figur 7;
- Figur 9: - eine perspektivische Ansicht eines aneinanderreihbaren Kunstoff- Formteils;
- Figuren 10 bis 12 -: verschiedene Ansichten des Kunststoff-Formteils gemäß Figur 9;
- Figur 13 -: eine perspektivische Ansicht eines Seitenteils der Abdeckhaube;
- Figuren 14 und 15 -: eine Innenseitenansicht und einen Schnitt durch das Seitenteil gemäß Figur 13.

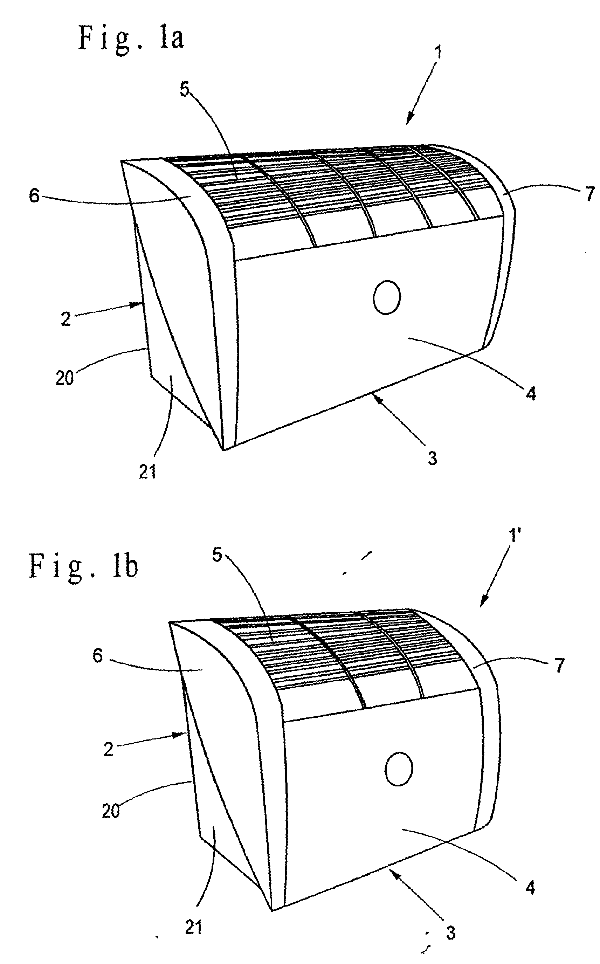

Figur 1 zeigt in perspektivischer Ansicht zwei Gehäuse 1, 1' für Telekommunikationsanlagen unterschiedlicher Größe. Beide Gehäuse 1, 1' sind identisch aufgebaut, unterscheiden sich aber durch eine unterschiedliche Gehäusebreite und sollen die modulare Bauweise des erfindungsgemäßen Gehäuses für Telekommunikationsanlagen verdeutlichen.

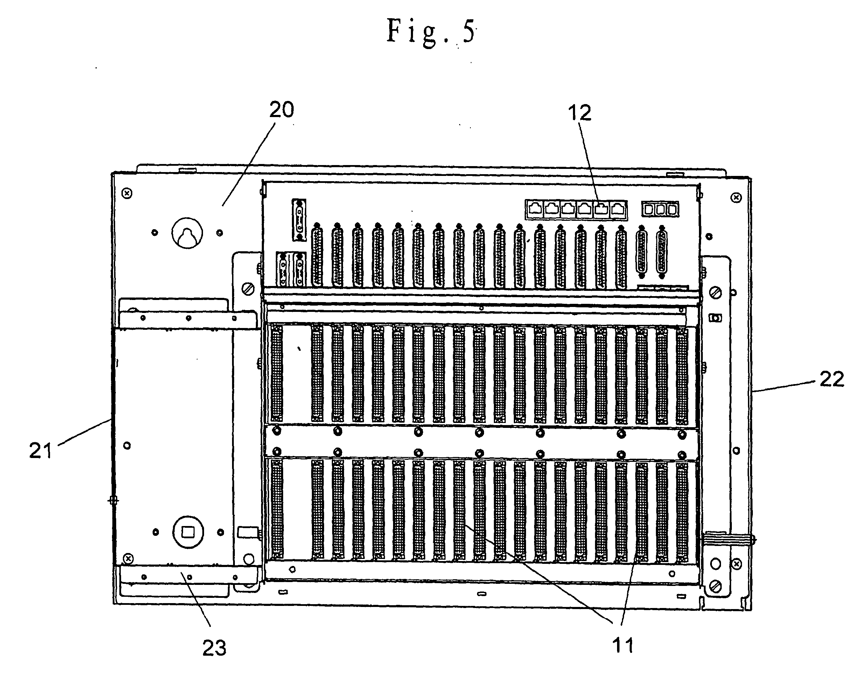

Jedes Gehäuse 1, 1' weist einen Gehäuseboden 2 mit einem Bodenteil 20 und zwei Seitenteilen 21, 22 (Fig. 5) auf, die vorzugsweise aus gewalztem und gestanztem Stahlblech oder aus einem Strangpreßprofil bestehen. Das Bodenteil 20 eigenet sich insbesondere zur Wandbefestigung und weist entsprechende Befestigungsvorrichtungen auf.

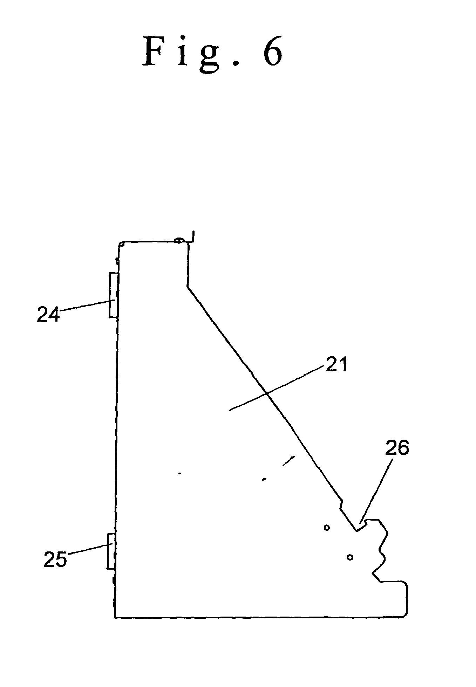

Gemäß Figur 5 ist mit dem Bodenteil 20 ein Baugruppenrahmen, beispielsweise ein 19-Zoll- oder ETSI-Baugruppenrahmen, zur Aufnahme von elektrischen oder elektronischen Baugruppen 11, 12, insbesondere für Steckkarten mit darauf angeordneten elektronischen Bauelementen, Steckbuchsen und einer Halterung 23 für eine Stromversorgungseinrichtung verbunden. Seitlich an dem Bodenblech 20 sind Seitenbleche 21, 22 angeordnet, von denen in Figur 6 das Seitenblech 21 dargestellt ist. Die Seitenbleche 21, 22 sind über Winkel 24, 25 und Abstandsbolzen sowie Befestigungsmuttern mit dem Bodenblech 20 verbunden.

Zur Abdeckung des mit dem Bodenblech 20 verbundenen Baugruppenrahmens oder -trägers bzw. der Stecker, elektrischen und elektronischen Bauelemente sowie Stromversorgungseinrichtungen dient eine Abdeckhaube 3, die sich aus einem Mantelblech 4, am oberen Teil des Mantelblechs angeordneten, aneinander reihbaren Kunstoff-Formteilen 5 sowie zwei Seitenteilen 6, 7 besteht, die vorzugsweise ebenfalls als Kunststoff-Formteile ausgebildet sind.

Das Bodenblech 20 des Gehäusebodens 2 und das Mantelblech 4 der Abdeckhaube 3 können je nach Größe des Gehäuses aus unterschiedlich breiten Stahlblechen gestanzt bzw. im Strangpressverfahren hergestellt werden und gestatten in Verbindung mit den aneinanderreihbaren Kunststoff-Formteilen 5, die als eine Wandfläche der Abdeckhaube die Oberseite und das Lüftungsgitter der Abdeckhaube 3 bilden, einen modularen Aufbau für unterschiedlich große Gehäuse für Telekommunikationsanlagen.

So zeigt Figur 1a ein Gehäuse 1 für Telekommunikationsanlagen, dessen Breite durch fünf aneinandergereihte Kunststoff-Formteile 5 der Abdeckhaube 3 bestimmt ist, während Figur 1b ein kleineres Gehäuse 1' zeigt, dessen Breite durch die Aneinanderreihung von drei Kunststoff-Formteilen bzw. Lüftungsgittern gegeben ist.

Bei beiden Gehäusen 1, 1' werden identische Seitenteile 6, 7 der Abdeckhaube 3 sowie identische Seitenbleche 21, 22 des Gehäusesbodens 2 verwendet.

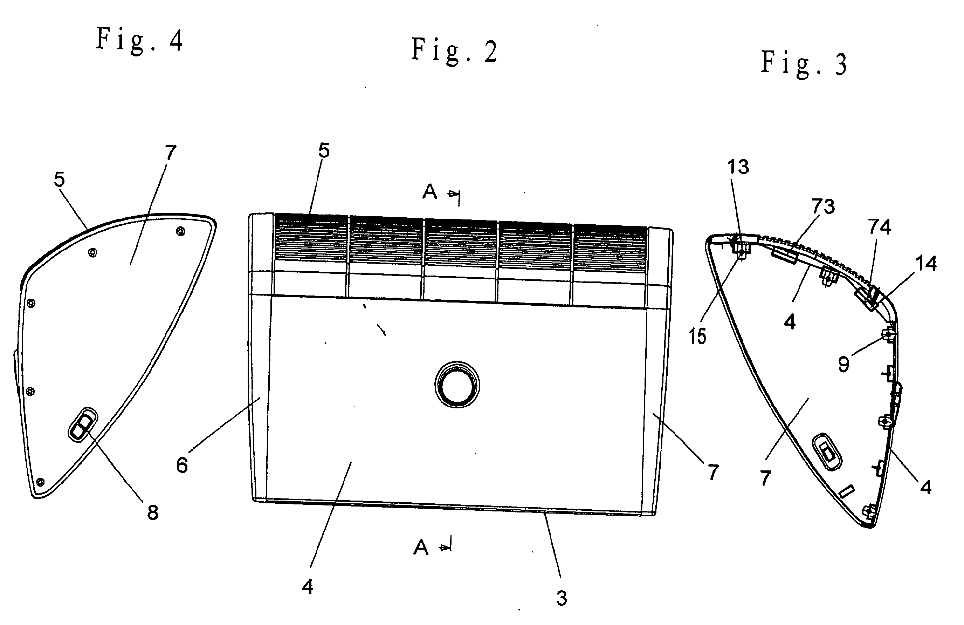

Anhand der Figuren 2 bis 4 soll die Konstruktion und Gestaltung der Abdeckhaube näher erläutert werden.

Figur 2 zeigt in einer Frontansicht die Abdeckhaube 3 und Figur 3 einen Schnitt durch die Abdeckhaube 3 entlang der Linie A-A gemäß Figur 2, die den inneren Aufbau sowie die konstruktiven Zusammenhänge besser erkennen läßt.

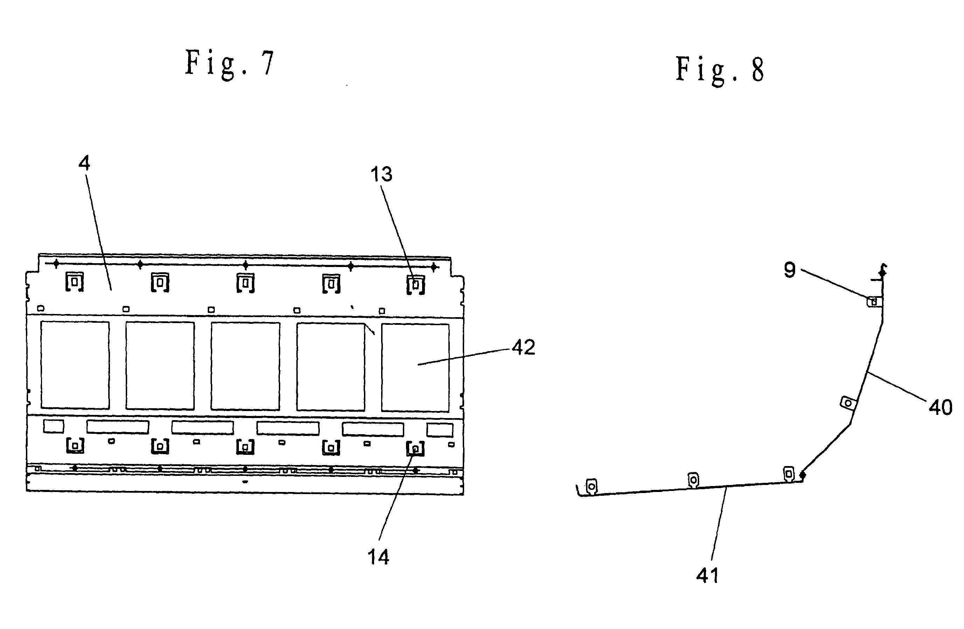

Die Abdeckhaube 3 enthält ein formgebendes Mantelblech 4, das gemäß den Figuren 7 und 8 aus zwei Teilen 40, 41 zusammengesetzt ist, wobei das Mantelblech aus gewalztem oder im Strangpressverfahren hergestellten und geformten Blech besteht. Das Mantelblech 4 weist mehrere Befestigungslaschen 9, 13, 14 zum Befestigen der Seitenteile 6, 7 sowie der aneinanderreihbaren Kunststoff-Formteile 5 auf. Diese Befestigungslaschen 9, 13, 14 sind gemäß den Figuren 7 und 8 vom Mantelblech abgewinkelt bzw. aus dem Mantelblech ausgestellt und enthalten eine Bohrung zur Aufnahme von Befestigungsstiften, die von der Innenseite der Seitenteile 6, 7 der Abdeckhaube 3 bzw. der aneinanderreihbaren Kunststoff-Formteile 5 abstehen.

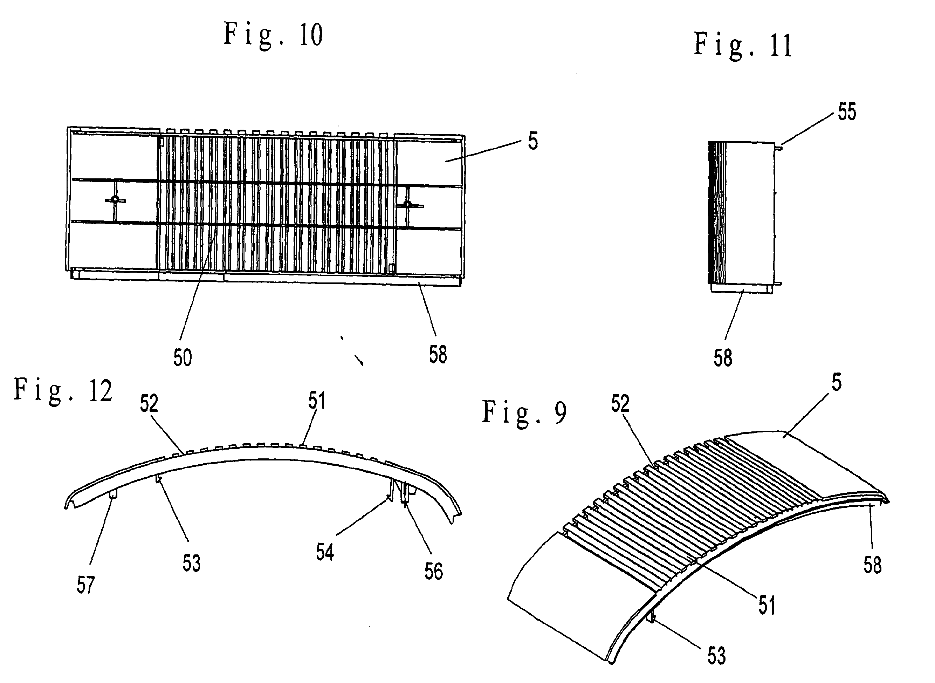

Die aneinanderreihbaren Kunststoff-Formteile 5 weisen gemäß den Figuren 9 und 12 von der Innenfläche abstehende Federhaken 53, 54 auf, die in entsprechende Öffnungen am Mantelblech 4 eingreifen und zur Positionierung der aneinanderreihbaren Kunststoff-Formteile 5 dienen.

Zur Arretierung und Verbindung der Abdeckhaube 3 mit dem Gehäuseboden 2 gemäß Figur 1 dient ein Schieber 8 an den Seitenteilen 6, 7, der im arretierten Zustand der Abdeckhaube 3 hinter eine Hinterschneidung 26 gemäß Figur 6 greift, so dass die Seitenteile 6, 7 und damit die Abdeckhaube 3 mit den Seitenblechen 21, 22 und damit mit dem Gehäuseboden 2 verbunden sind. Der Schieber 8 kann zur Sicherung der Verriegelung mit entsprechenden Sicherungselementen verbunden sein bzw. seiner Lage durch entsprechende Sicherungselemente gesichert werden. Damit wird verhindert, daß die Abdeckhaube 3 unabsichtlich bzw. unbefugt von dem Gehäuseboden 2 gelöst wird und damit die elektronischen Bauteile im Inneren des Gehäuses 1 bzw 1' für Unbefugte zugänglich werden.

Ein derartiges Sicherungselement kann aus einer entsprechenden Verriegelung des Schiebers 8 bestehen, die beispielsweise nur mit einem Spezialwerkzeug zu öffnen ist bzw. eine nur dem Fachmann geläufige Handhabung erfordert.

Wie der Draufsicht auf das Mantelblech 4 gemäß Figur 7 zu entnehmen ist, weist das Mantelblech 4 im oberen Teil der Abdeckhaube 3 Öffnungen 42 auf, die zur Wärmeabfuhr der mit dem Bodenblech 20 verbundenen elektrischen und elektronischen Bauteile dienen. Diese Öffnungen 42 werden gemäß den die aneinanderreihbaren Kunststoff-Formteile 5 in perspektivischer Ansicht, in Draufsicht, Seitenansicht und Stirnseitenansicht zeigenden Figuren 9 bis 12 durch die Lüftungsgitter 50 der aneinanderreihbaren Kunststoff-Formteile 5 abgedeckt. Die Lüftungsgitter 50 werden durch parallele Gitterstege 51 und Öffnungsschlitze 52 gebildet, die miteinander abwechseln. Die Öffnungsschlitze 52 und Gitterstege 52 sind in einem Bereich der aneinanderreihbaren Kunststoff-Formteile 5 vorgesehen, der die Öffnungen 42 im Mantelblech 4 abdeckt.

Die aneinanderreihbaren Kunststoff-Formteile 5 weisen weiterhin die vorstehend erwähnten federnden Haken 53, 54 auf, mit denen die aneinanderreihbaren Kunststoff-Formteile 5 währen der Montage am Mantelblech 4 festlegbar sind. Die federnden Haken 53, 54 sind vorzugsweise an dem einen bzw. anderen Seitenrand der Kunststoff-Formteile 5 angeordnet, so das eine einfache Positionierung und vorläufige Lagefestlegung der Kunststoff-Formteile 5 möglich ist.

Zur Verbindung der Kunststoff-Formteile 5 mit dem Mantelblech 4 dienen die ebenfalls vorstehend erwähnten, von der Innenfläche der Kunststoff-Formteile 5 abstehenden Befestigungsstifte 56, 57, die durch die Öffnungen in den Befestigungslaschen 13, 14 des Mantelblechs 4 steckbar sind. Auf die durch die Befestigungslaschen 13, 14 gesteckten Stifte 56, 57 werden Federmuttern 15 gemäß Figur 3 aufgesetzt und gegen die Befestigungslaschen gedrückt, wobei die Federmuttern 15 in die Stifte 56, 57 einschneiden und damit eine feste form- und kraftschlüssige Verbindung zwischen den Kunststoff-Formteilen 5 und dem Mantelblech 4 herstellen.

Zur Aneinanderreihung der Kunststoff-Formteile 5 wiesen die Kunststoff-Formteile 5 einen abstehenden Seitenrand 58 auf, der vom gegenüberliegenden Seitenrand des jeweils benachbarten Kunststoff-Formteiles abgedeckt wird, so dass eine lückenlose Aneinanderreihung der Kunststoff-Formteile 5 zur Herstellung eines geschlossenen Lüftungsgitters gewährleistet ist. Gleichzeitig dient die überlappende Aneinanderreihung der Kunststoff-Formteile 5 der zusätzlichen Lagesicherung und einem geschlossenen, gefälligen Aussehen der Abdeckhaube 3.

In Abwandlung von der vorstehenden beschriebenen Befestigung der Kunststoff-Formteile 5 am Mantelblech 4 kann an Stelle von zwei Stiften 56, 57 auch ein einzelner Stift vorgesehen werden, wenn eine Stirnseite der Kunststoff-Formteile 5 mit einem Hinterschnitt versehen ist, der beispielsweise in eine entsprechende Lasche des Mantelblechs 4 der Abdeckhaube 3 eingreift.

Die Seitenteile 6, 7 der Abdeckhaube 3 werden in ähnlicher Weise mit dem Mantelblech 4 verbunden wie die aneinanderreihbaren Kunststoff-Formteile 5 mit dem Mantelblech 4 verbunden werden.

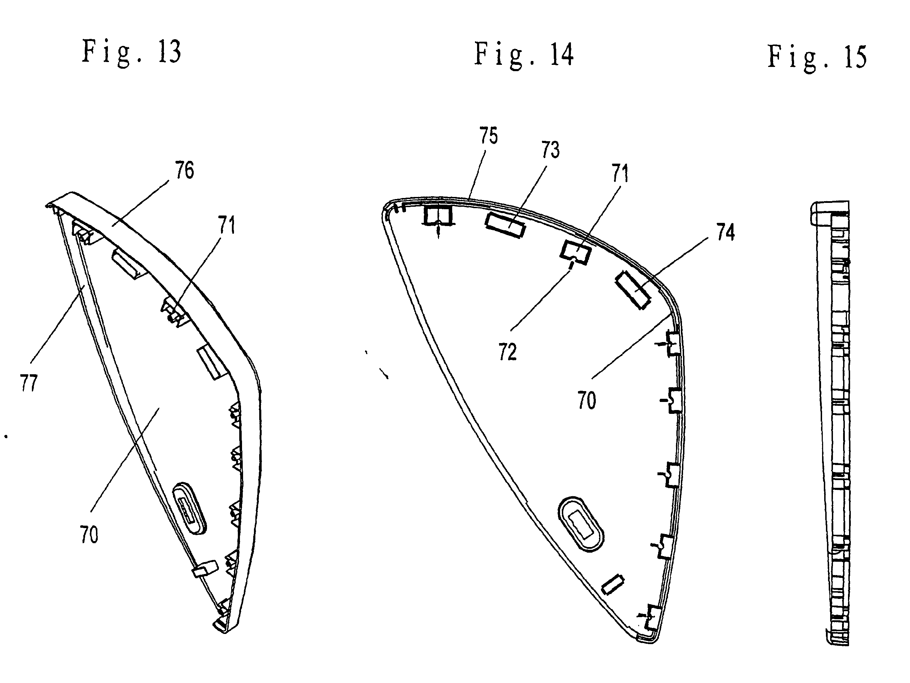

Figur 13 zeigt in perspektivscher Darstellung und Figur 14 in einer Innenseitenansicht, sowie Figur 15 in einem Längsschnitt eines der beiden Seitenteile 6, 7 gemäß Figur 2.

Die Seitenteile 6, 7 weisen von der Innenwand abstehende Aufnahmen 73, 74 mit der Kontur und Dicke des Mantelblechs 4 angepaßten Schlitzen auf, mit denen die Seitenteile 6, 7 auf das Mantelblech 4 gemäß Figur 3 aufgesteckt werden. Zur Befestigung der Seitenteile 6, 7 an dem Mantelblech 4 dienen in Abstandshülsen 71 integrierte Stifte 72, wobei die Abstandshülsen 71 ebenfalls Aufnahmen mit Schlitzen zur Verbindung mit dem Mantelblech 4 aufweisen. Die Stifte 72 werden durch Öffnungen in den Befestigungslaschen 9 des Mantelblechs 4 gesteckt und durch Aufstecken und Anziehen von Federmuttern 15 mit dem Mantelblech 4 verbunden.

Die obere Seitenkante 75 der Seitenteile 6, 7 weist ebenfalls eine Hinterschneidung auf, so dass die Seitenränder der äußeren Kunststoff-Formteile 5 von den Seitenteilen 6, 7 abgedeckt werden und damit ein geschlossenes, gefälliges Aussehen der Abdeckhaube 3 gewährleistet ist.

Das vorstehend beschriebene Ausführungsbeispiel kann in mannigfaltiger Weise variert werden. Der modulare Aufbau des erfindungsgemäßen Gehäuses für Telekommunikationanlagen wurde vorstehend anhand von identischen Kunststoff-Formteilen beschrieben, die jedoch zur Erhöhung der Variationsbreite aus unterschiedlichen Grundelementen mit verschiedenen Breiten bestehen können.

Allen Konstruktionen liegt aber der gemeinsamen der Gedanke zu Grunde, einerseits Stahlblechteile mit Formteilen aus Kunststoff zu verbinden, um ein äußerst stabiles und formschönes Gehäuse zu schaffen, andererseits aber eine leichte Montage und eine kostengünstige Herstellung durch die Verknüpfung von Kunststoff und Metall zu erzielen, wobei für den Herstellungsprozess die jeweils günstigste Herstellungform für die Kunststoff-Formteile bzw. die Stahlblechteile gewählt wird. Da insbesondere die Herstellung von Formteilen aus Metall äußerst kostenaufwendig ist, wird durch die Verwendung von Kunststoff-Formteilen für komplizierte Formen der Material- und Herstellungsaufwand deutlich reduziert und die Herstellung erheblich vereinfacht.

## Patentansprüche

1. Gehäuse für Telekommunikationsanlagen mit einem Gehäuseboden zur Aufnahme von Baugruppen oder Baugruppenrahmen und einer lösbar mit dem Gehäuseboden verbundenen Abdeckhaube, die mit dem Gehäuseboden die Baugruppen oder Baugruppenrahmen umschließt,
**dadurch gekennzeichnet,**
**daß** die Abdeckhaube (3) aus einem zumindest einen Teil der Abdeckhaube (3) bildenden Mantelblech (4) und aus Kunststoff-Formteilen (5, 6, 7) besteht, die teilweise mit dem Mantelblech (4) und/oder dem Gehäuseboden (2) verbunden sind und daß ein Teil der Kunststoff-Formteile (5) zur Bildung einer Wandfläche der Abdeckhaube (3) aneinanderreihbar ist.

2. Gehäuse nach Anspruch 1, **dadurch gekennzeichnet, daß** die aneinanderreihbaren Kunststoff-Formteile (5) an ihren Innenflächen mit der Außenfläche des Mantelblechs (4) verbunden sind.

3. Gehäuse nach Anspruch 2, **dadurch gekennzeichnet, daß** die aneinanderreihbaren Kunststoff-Formteile (5) identisch ausgebildet sind und daß die Breite des Mantelblechs (4) im wesentlichen ein ganzzahliges Vielfaches der Breite der aneinanderreihbaren Kunststoff-Formteile (5) ist.

4. Gehäuse nach Anspruch 2, **dadurch gekennzeichnet, daß** die aneinanderreihbaren Kunststoff-Formteile (5) dieselbe Länge aber unterschiedliche Breiten aufweisen und daß die Breite des Mantelblechs (4) im wesentlichen der Summe der Breite aller aneinanderreihbaren Kunststoff-Formteile (5) ist.

5. Gehäuse nach Anspruch 4, **dadurch gekennzeichnet, daß** die Breite der aneinanderreihbaren Kunststoff-Formteile (5) jeweils ein ganzzahliges Vielfaches der Breite eines Grundelements der aneinanderreihbaren Kunststoff-Formteile (5) ist.

6. Gehäuse nach einem der voranstehenden Ansprüche, **dadurch gekennzeichnet, daß** die aneinanderreihbaren Kunststoff-Formteile (5) ein Lüftungsgitter (50) enthalten, das mindestens eine Öffnung (42) im Mantelblech (4) abdeckt.

7. Gehäuse nach einem der voranstehenden Ansprüche, **dadurch gekennzeichnet, daß** die aneinanderreihbaren Kunststoff-Formteile (5) mit federnden Haken (53, 54) am Mantelblech (4) festlegbar sind und durch Befestigungslaschen (13, 14) im Mantelblech (4) steckbare, im wesentlichen senkrecht von der Innenfläche der aneinanderreihbaren Kunststoff-Formteile (5) abstehende Befestigungsstifte (56, 57) aufweisen, und daß die aneinanderreihbaren Kunststoff-Formteile (5) mittels auf die Befestigungsstifte (56, 57) aufsteckbare Federmuttern (15) mit dem Mantelblech (4) verbindbar sind.

8. Gehäuse nach einem der voranstehenden Ansprüche, **dadurch gekennzeichnet, daß** die aneinanderreihbaren Kunststoff-Formteile (5) an ihren einander zugewandten Seitenkanten sich überdeckende Flächenbereiche (58) aufweisen.

9. Gehäuse nach einem der voranstehenden Ansprüche, **dadurch gekennzeichnet, daß** die aneinanderreihbaren Kunststoff-Formteile (5) in Längsrichtung gebogen sind.

10. Gehäuse nach einem der voranstehenden Ansprüche, **dadurch gekennzeichnet, daß** die als Kunststoff-Formteile ausgebildeten Seitenteile (6, 7) der Abdeckhaube (3) einen die Seitenkante des Mantelblechs (4) sowie die jeweils äußeren aneinanderreihbaren Kunststoff-Formteile (5) teilweise und die Seitenteile (21, 22) des Gehäusebodens (2) abdeckenden, hochgezogenen Rand (76, 77) aufweisen und über zueinander ausgerichtete Formschlußelemente (9, 73, 74) mit dem Mantelblech (4) verbunden sind.

11. Gehäuse nach Anspruch 10, **dadurch gekennzeichnet, daß** die Seitenteile (6, 7) der Abdeckhaube (3) einen in die Fläche der Seitenteile (6, 7) eingelassenen Schieber (8) aufweisen, der zur Verbindung mit dem Gehäuseboden (2) eine Formschlußöffnung (26) des Gehäusebodens (2) hintergreift.

12. Gehäuse nach Anspruch 11, **dadurch gekennzeichnet, daß** der Schieber (8) ein die Verstellung des Schiebers (8) blockierendes Element enthält.

13. Gehäuse nach Anspruch 11, **dadurch gekennzeichnet, daß** der Schieber (8) mit einem die Verstellung des Schiebers (8) blockierenden Element verbindbar ist.

14. Gehäuse nach einem der voranstehenden Ansprüche 10 bis 13, **dadurch gekennzeichnet, daß** eine im montierten Zustand der Abdeckhaube (3) von der Innenfläche der Seitenteile (6, 7) abstehende Zentrierkontur in einen Zentrierschlitz des Gehäusebodens (2) eingreift.

15. Gehäuse nach einem der voranstehenden Ansprüche, **dadurch gekennzeichnet, daß** das Mantelblech (4) aus gewalztem oder gerolltem Stahlblech besteht.

16. Gehäuse nach einem der voranstehenden Ansprüche 1 bis 14, **dadurch gekennzeichnet, daß** das Mantelblech (4) aus einem Strangpreßprofil besteht.

## Claims

1. Housing for telecommunications systems, having a housing base for accommodating modules or module frames, and having a covering shroud which is connected releasably to the housing base and, with the housing base, encloses the modules or module frames, **characterized in that** the covering shroud (3) comprises a casing plate (4), which forms at least part of the covering shroud (3), and plastic moldings (5, 6, 7), which are connected, in part, to the casing plate (4) and/or the housing base (2), and **in that** some of the plastic moldings (5) can be lined up in a row one beside the other in order to form a wall surface of the covering shroud (3).

2. Housing according to Claim 1, **characterized in that** the plastics moldings (5), which can be lined up in a row one beside the other, are connected, on their inner surfaces, to the outer surface of the casing plate (4).

3. Housing according to claim 2, **characterized in that** the plastic moldings (5), which can be lined up in a row one beside the other, are of identical design, and **in that** the width of the casing plate (4) is essentially a whole-numbered multiple of the width of the plastic moldings (5), which can be lined up in a row one beside the other.

4. Housing according to Claim 2, **characterized in that** the plastic moldings (5), which can be lined up in a row one beside the other, are of the same length but of different widths, and **in that** the width of the casing plate (4) is essentially equal to the sum of the width of all the plastic moldings (5), which can be lined up in a row one beside the other.

5. Housing according to Claim 4, **characterized in that** the width of the plastic moldings (5), which can be lined up in a row one beside the other, is in each case a whole-numbered multiple of the width of a basic element of the plastic moldings (5), which can be lined up in a row one beside the other.

6. Housing according to one of the preceding claims, **characterized in that** the plastic moldings (5), which can be lined up in a row one beside the other, contain in a ventilation grille (50) which covers at least one opening (42) in the casing plate (4).

7. Housing according to one of the preceding claims, **characterized in that** the plastic moldings (5), which can be lined up in a row one beside the other, can be secured on the casing plate (4) by resilient hooks (53, 54) and have fastening pins (56, 57) which can be plugged through fastening lugs (13, 14) in the casing plate (4) and project essentially perpendicularly from the inner surface of the plastic moldings (5), which can be lined up in a row one beside the other, and **in that** the plastic moldings (5), which can be lined up in a row one beside the other, can be connected to the casing plate (4) by means of resilient nuts (15) which can be plugged onto the fastening pins (56, 57).

8. Housing according to one of the preceding claims, **characterized in that** the plastic moldings (5), which can be lined up in a row one beside the other, have overlapping surface regions (58) on their mutually facing side edges.

9. Housing according to one of the preceding claims, **characterized in that** the plastic moldings (5), which can be lined up in a row one beside the other, are bent in the longitudinal direction.

10. Housing according to one of the preceding claims, **characterized in that** the side parts (6, 7) of the covering shroud (3), which are designed as plastic moldings, have an upwardly extended border (76, 77), which covers, in part, the side edge of the casing plate (4) and the respectively outer plastic moldings (5), which can be lined up in a row one beside the other, and the side parts (21, 22) of the housing base (2), and are connected to the casing plate (4) via form-fitting elements (9, 73, /4) which are aligned in relation to one another.

11. Housing according to Claim 10, **characterized in that** the side parts (6, 7) of the covering shroud (3) have a slide (8) which is positioned in the surface of the side parts (6, 7) and, for connection to the housing base (2), engages behind a form-fitting opening (26) of the housing base (2).

12. Housing according to Claim 11, **characterized in that** the slide (8) contains an clement which blocks the adjustment of the slide (8).

13. Housing according to Claim 11, **characterized in that** the slide (8) can be connected to an element which blocks the adjustment of the slide (8).

14. Housing according to one of the preceding Claims 10 to 13, **characterized in that** a centering contour which, in the installed state of the covering shroud (3), projects from the inner side of the side parts (6, 7) engages in a centering slot of the housing base (2).

15. Housing recording to one of the preceding claims, **characterized in that** the casing plate (4) consists of rolled sheet steel.

16. Housing according to one of the preceding Claims 1 to 14, **characterized in that** the casing plate (4) comprises an extruded profile.

## Revendications

1. Boîtier pour centraux de télécommunications avec un fond de boîtier destiné à recevoir des modules ou des cadres de modules et une coiffe de recouvrement amovible assemblée au fond de boîtier, qui entoure avec le fond de boîtier les modules ou les cadres de modules, **caractérisé en ce que** la coiffe de recouvrement (3) se compose d'une tôle d'enveloppe (4) formant au moins une partie de la coiffe de recouvrement. (3) et de pièces moulées en plastique (5, 6, /), qui sont en partie assemblées à la tôle d'enveloppe (4) et/ou au fond de boîtier (2) et **en ce qu'**une partie des pièces moulées en plastique (5) peut être alignée en continu pour former une surface de paroi de la coiffe de recouvrement (3).

2. Boîtier selon la revendication 1, **caractérise en ce que** les pièces moulées en plastique (5) pouvant être alignées en continu sont assemblées sur leurs faces intérieures avec la face extérieure de la tôle d'enveloppe (4).

3. Boîtier selon la revendication 2, **caractérisé en ce que** les pièces moulées en plastique (5) pouvant être alignées en continu sont de forme identique et **en ce que** la largeur de la tôle d'enveloppe (4) est pour l'essentiel un multiple entier de la largeur des pièces moulées en plastique (5) pouvant être alignées en continu.

4. Boîtier selon la revendication 2, **caractérisé en ce que** les pièces moulées en plastique (5) pouvant être alignées en continu présentent la même longueur mais des largeurs différentes, et **en ce que** la largeur de la tôle d'enveloppe (4) est essentiellement la somme de la largeur de toutes les pièces moulées en plastique (5) pouvant être alignées en continu.

5. Boîtier selon la revendication 4, **caractérisé en ce que** la largeur des pièces moulées en plastique (5) pouvant être alignées en continu est chaque fois un multiple entier de la largeur d'un élément de base des pièces moulées en plastique (5) pouvant être alignées en continu.

6. Boîtier selon l'une quelconque des revendications précédentes, **caractérise en ce que** les pièces moulées en plastique (5) pouvant être alignées en continu contiennent une grille d'aération (50), qui masque au moins une ouverture (42) dans la tôle d'enveloppe (4).

7. Boîtier selon l'une quelconque des revendications précédentes, **caractérisé en ce que** les pièces moulées en plastique (5) pouvant être alignées en continu peuvent être fixées à la tôle d'enveloppe (4) avec des crochets à ressort (53, 54) et comportent des tiges de fixation (56, 57) saillantes essentiellement perpendiculairement sur la face intérieure des pièces moulées en plastique (b) pouvant être alignées en continu et enfichables à travers des pattes de fixation (13, 14) dans la tôle d'enveloppe (4), et **en ce que** les pièces moulées en plastique (b) pouvant être alignées en continu peuvent être assemblées à la tôle d'enveloppe (4) au moyen des écrous à ressort (15) enfichables sur les tiges de fixation (56, 57).

8. Boîtier selon l'une quelconque des revendications précédentes, **caractérisé en ce que** les pièces moulées en plastique (5) pouvant être alignées en continu présentent des zones de surface (58) qui se recouvrent dans leurs bords latéraux tournés l'un vers l'autre.

9. Boîtier selon l'une quelconque des revendications précédentes, **caractérisé en ce que** les pièces moulées en plastique (5) pouvant être alignées en continu sont courbées en direction longitudinale.

10. Boîtier selon l'une quelconque des revendications précédentes, **caractérisé en ce que** les pièces latérales (6, 7) de la coiffe de recouvrement (3), constituées par des pièces moulées en plastique, présentent un bord surélevé (76, 77) recouvrant le bord latéral de la tôle d'enveloppe (4) ainsi que partiellement les pièces moulées en plastique (5) pouvant, être alignées en continu respectivement extérieures et les parties latérales (21, 22) du fond de boîtier (2) et sont assemblées à la tôle d'enveloppe (4) par des éléments moulés emboîtes (9, 73, 74) orientés l'un vers l'autre.

11. Boîtier selon la revendication 10, **caractérisé en ce que** les pièces latérales (6, 7) de la coiffe de recouvrement (3) présentent un verrou (8) inséré dans la surface des pièces latérales (6, 7), qui s'accroche à l'arrière d'une ouverture d'emboîtement (26) du fond de boîtier (2) pour leur assemblage avec le fond de boîtier (2).

12. Boîtier selon la revendication 11, **caractérisé en ce que** le verrou (8) comprend un élément bloquant le déplacement du verrou (8) .

13. Boîtier selon la revendication 11, **caractérisé en ce que** le verrou (8) peut être assemblé à un élément bloquant le déplacement du verrou (8).

14. Boîtier selon l'une quelconque des revendications précédentes 10 à 13, **caractérisé en ce qu'**un contour de centrage saillant sur la face intérieure des pièce latérales (6, 7) s'engage, à l'état monté de la coiffe de recouvrement (3), dans une fente de centrage du fond de boîtier (2).

15. Boîtier selon l'une quelconque des revendications précédentes, **caractérisé en ce que** la tôle d'enveloppe (4) se compose d'une tôle d'acier laminée ou roulée.

16. Boîtier selon l'une quelconque des revendications précédentes 1 à 14, **caractérisé en ce que** la tôle d'enveloppe (4) se compose d'un profilé extrudé.
